# EUROPÄISCHE PATENTSCHRIFT

(11) **EP 1 146 341 B1**
(45) Veröffentlichungstag und Bekanntmachung des Hinweises auf die Patenterteilung: **03.05.2006**
(21) Anmeldenummer: 00127323.4
(22) Anmeldetag: 13.12.2000
(51) Int. Cl.: G01R 1/06, G01R 31/04, G01R 1/04

(54) **Teststecker für Reihenklemmen**
Test connector for series terminal
Connecteur de test pour borne de raccordement en série

(30) Priorität: 16.02.2000 DE 20002713 U
(43) Veröffentlichungstag der Anmeldung: 17.10.2001
(73) Patentinhaber: Weidmüller Interface GmbH & Co., 32760 Detmold (DE)
(72) Erfinder: Rutz, Andreas, 33609 Bielefeld (DE); Wilmes, Manfred, 32760 Detmold (DE); Stuckmann, Peter, 32791 Lage (DE); Diekmann, Jörg, 33813 Oerlinghausen (DE); Lütkemeier, Ulrich, 32758 Detmold (DE); Homeier, Frank, 32758 Detmold (DE)
(74) Vertreter: Dantz, Jan Henning

(56) Entgegenhaltungen:
- EP-A- 0 621 483
- DE-A- 19 629 445
- DE-U- 9 420 515
- US-A- 5 391 082

## Beschreibung

Die Erfindung betrifft einen Teststecker für Reihenklemmen, insbesondere für Durchgangsreihenklemmen zum Aufrasten auf eine Tragschiene, wobei die Reihenklemmen ein Klemmengehäuse, in welchem Leiteranschlüsse angeordnet sind, Öffnungen zum Zuführen der Leiter und weitere Öffnungen aufweisen, und wobei der Teststecker einen Teststeckerkontakt mit einem Kontaktbein zum Einführen in eine der weiteren Öffnungen des Klemmengehäuses und zur Kontaktierung des Leiteranschlusses aufweist.

Teststecker sind aus der DE 94 20 515 U oder der EP-A- 0 621 483 bekannt. DE 9420515 N beschreibt einer Teststecker mit einem Kontaktbeln, welches Mittel zu Kontaktierung eines Leiteranschlußes und Mittel zum Verrasten an einem klemmengehäuse aufweist.

Ein gattungsgemäßer Teststecker ist aus der DE 43 12 667 C2 bekannt. Die Schrift zeigt einen Teststecker für Reihenklemmen, der ein Steckergehäuse aufweist, welches mit einem abgefedert verschieblich geführten, mit einem Leiter verbundenen Prüfkontaktstift für Testoperationen versehen ist, wobei an dem Steckergehäuse ein in eine Zugangsöffnung des Reihenklemmengehäuses einsteckbares Bein vorgesehen ist, das an seinem unteren Ende einen Rasthaken zum Untergreifen einer Klemmengehäusekontur aufweist. Dieses Bein ist als schwenkbar am Steckergehäuse gelagerter Betätigungshebel ausgelegt, welcher in Verhakungsdrehrichtung unter Federkraft eingesetzt ist.

Diese Teststeckerauslegung hat sich zwar an sich bewährt. Insbesondere für besonders schmal bauende Klemmen (z.B. im Rastermaß 3,5 mm) ist es aber wünschenswert, die Mechanik des Teststeckers unter Beibehaltung der Rasthakenfunktion weiter zu vereinfachen. Der Lösung dieser Aufgabe widmet sich die Erfindung.

Die Erfindung löst diese Aufgabe durch den Gegenstand des Anspruches 1, also dadurch, daß das Kontaktbein als mehrlagig gefaltetes Stanz-/Biegeteil ausgelegt ist, welches wenigstens zwei relativ zueinander verschwenkbare Kontaktstege aufweist, von denen wenigstens einer zur Kontaktierung des Leiteranschlusses und wenigstens ein weiterer zum Verrasten am Klemmengehäuse ausgelegt ist. Durch die Erfindung wird ein Teststecker mit einem als Stanz-/Biegeteil kostengünstig herstellbaren Teststeckerkontakt geschaffen, welcher gegen ein unbeabsichtigtes Ausziehen aus der Reihenklemme senkrecht nach oben gut gesichert ist, der aber dennoch keinen aufwendig gestalteten Verriegelungsmechanismus benötigt. Durch die besonders sichere Verrastung gegen ein Abziehen nach oben unterscheidet sich die Anordnung auch vorteilhaft von Teststeckern, welche ebenfalls direkt in Öffnungen zum Einführen der Schraubendreher einsetzbar sind (z.B. aus der DE 197 08 914 C1), deren Abziehsicherheit aber nicht an die der vorliegenden Erfindung heranreicht.

Nach einem auch unabhängig zu betrachtenden Gedanken der Erfindung weist der Teststecker sowohl einen separater Prüfzugang als auch einen Leiteranschluß aufweist, so daß trotz angeschlossenem Leiter am Teststecker einfache zusätzliche Prüfabgriffe an der Klemme realisierbar sind.

Weitere vorteilhafte Ausgestaltungen der Erfindung sind den übrigen Unteransprüchen zu entnehmen.

Nachfolgend wird die Erfindung unter Bezug auf die Zeichnung anhand von Ausfiihrungsbeispielen näher beschrieben. Es zeigt:
- Fig. 1: eine Ansicht eines ersten Ausführungsbeispiels eines erfindungsgemäßen Teststeckers bei einer Prüfung an einer Reihenklemme, jeweils ohne Frontgehäuseteile;
- Fig. 2: eine Ansicht eines zweiten Ausführungsbeispiels eines erfindungsgemäßen Teststeckers bei einer Prüfung an einer Reihenklemme, jeweils ohne Frontgehäuseteile;
- Fig. 3: eine teilweise Sprengansicht von Elementen aus Fig. 2;

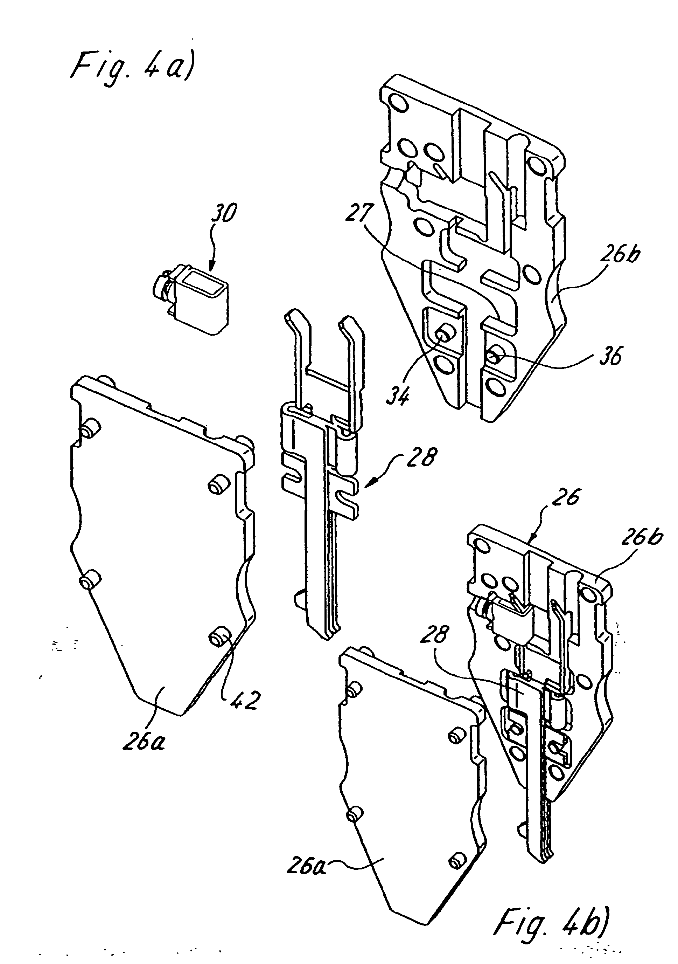

- Fig. 4a,b: verschiedene Sprengansichten von Elementen des Teststeckers aus Fig. 2;
- Fig. 5: eine Detailansicht des Prüfkontaktes des Teststeckers aus Fig. 1 und 2;
- Fig. 6: eine Detailansicht der Teststeckerspitze im Klemmengehäuse nach Art der Fig. 1 und 2;
- Fig. 7: den Einsatz von zwei Teststeckern an einer Reihenklemme.

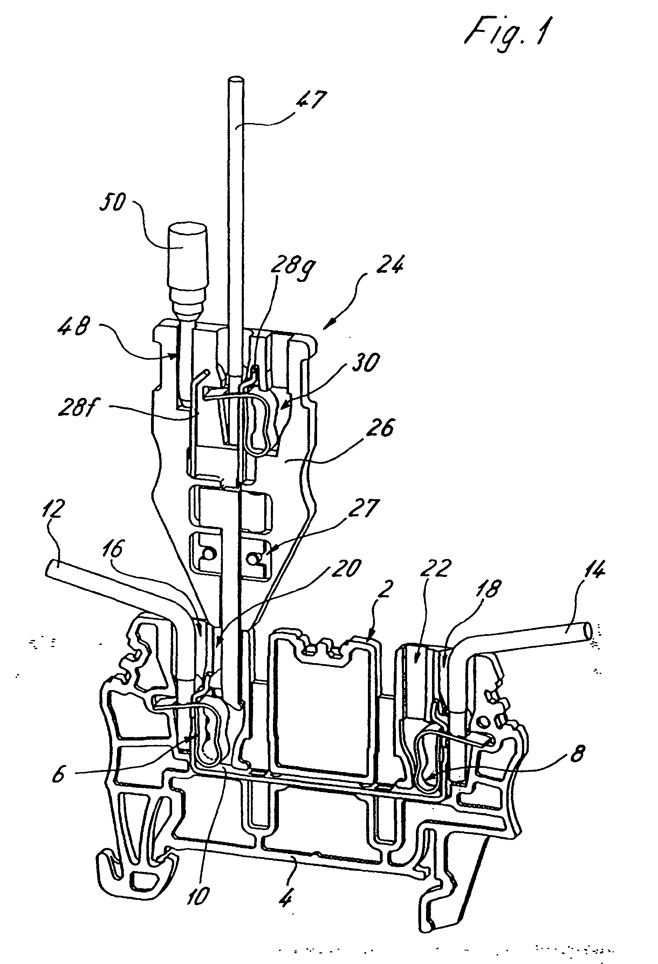

Fig. 1 zeigt eine Durchgangsreihenklemme 2 zum Aufrasten auf eine Tragschiene mit einem Klemmengehäuse 4, in welchem Zugfederanschlüsse 6, 8 angeordnet sind, welche über eine Stromschiene 10 miteinander verbunden sind. Die Enden der Leiter 12, 14 lassen sich relativ zur Tragschienenrichtung senkrecht von oben durch Öffnungen 16, 18 in die Zugfederanschlüsse 6, 8 einführen.

Parallel zu den Öffnungen 16, 18 sind weitere Öffnungen 20, 22 vorgesehen, welche als Betätigungsöffnungen für einen Schraubendreher zum Öffnen der Klemmenfederanschlüsse und auch zum Einsetzen der Teststecker 24 dienen.

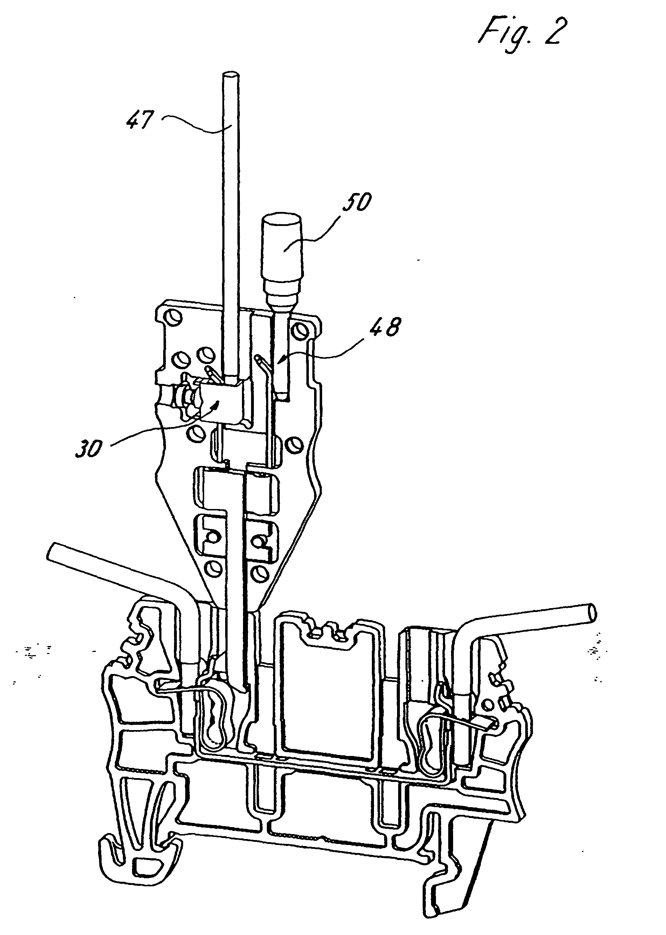

Die Teststecker 24 weisen jeweils ein im wesentlichen aus einem Vorderteil 26a und einem Rückteil 26b zusammensetzbares Kunststoffgehäuse 26 auf, in dem eine Kontur 27 zum Einlegen der Metallteile des Teststeckers 24 ausgebildet ist. Diese Metallteile umfassen einen Teststeckerkontakt 28 zum Einführen in die Öffnungen 20, 22 der Reihenklemme 2 sowie einen daran angesetzten/angeformten Leiteranschluß 30, der nach Fig. 1 als Zugfederanschluß und nach Fig. 2 als Schraubanschluß ausgebildet ist.

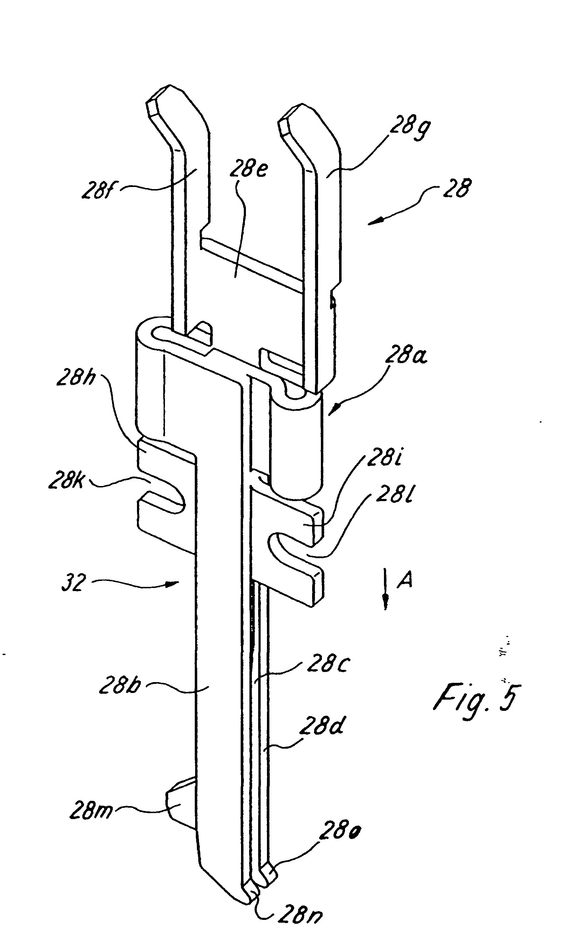

Der Teststeckerkontakt 28 ist - wie in Fig. 5 besonders gut zu erkennen - als Stanz-/Biegeteil (z.B. aus Kupferblech) ausgebildet. Er weist einen senkrecht zur Einsteckrichtung A verlaufenden zentralen Steg 28a auf, an den in Einsteckrichtung im wesentlichen drei parallel zueinander ausgerichtete Kontaktstege 28b,c,d und entgegengesetzt zur Einsteckrichtung ein weiterer Steg 28e angeformt ist, an den sich wiederum zwei im wesentlichen parallel zur Einsteckrichtung A erstreckende Stromschienenstücke 28f,g anschließen. Im Bereich des zentralen Steges 28a ist der Teststeckerkontakt 28 zweimal um 180° umgebogen (parallel zur Einsteckrichtung A), und zwar derart, daß die Kontaktstege 28b,c,d direkt aneinander liegen und derart eine Art übergreifendes Teststeckerbein 32 ausbilden.

An zwei der Teststeckerkontaktstege 28b, 28d sind senkrecht zur Einsteckrichtung A verlaufende Lappen 28h, 28i angeformt, welche parallel zueinander ausgerichtet sind und vom Teststeckerbein nach außen abstehen. Sie weisen Ausnehmungen 28k, 1 auf, in die Stifte 34, 36 des Kunststoffgehäuses 26 eingreifen, die den Teststeckerkontakt 28 im Kunststoffgehäuse 4 führen und zentrieren.

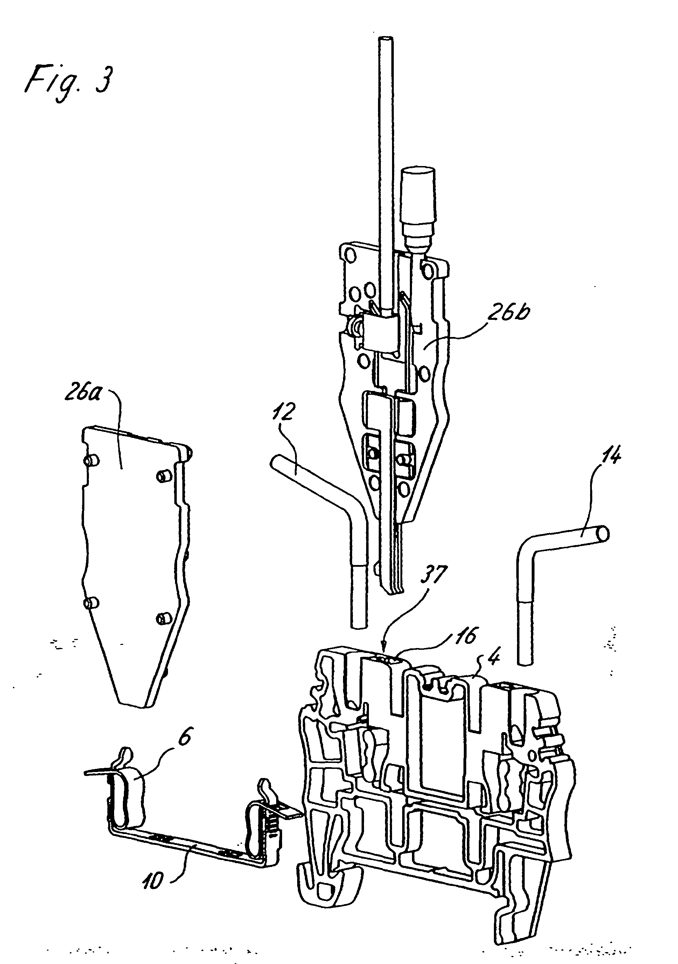

An einen der Kontaktstege - hier an den mittleren Kontaktsteg 28c - ist im unteren Bereich ein Kontaktschenkel 28m angeformt, der zum Kontaktieren der Stromschienenenden der Zugfederanschlüsse 6, 8 dient. An die beiden äußeren Kontaktstege 28b, 28d sind dagegen in der vom Kontaktschenkel 28m abgewandten Richtung Halteschenkel 28n,o angeformt, welche den Teststecker 24 in der Reihenklemme 2 verrasten und gegen ein unbeabsichtigtes Ausziehen aus der Reihenklemme 2 sichern. Die Schraubendreheröffnungen 20, 22 weisen entsprechend eine im wesentlichen rechteckige Geometrie (siehe z.B. Fig. 3) mit einer einseitigen Aussparung 37 zur Durchführung des Kontaktschenkels 28m auf.

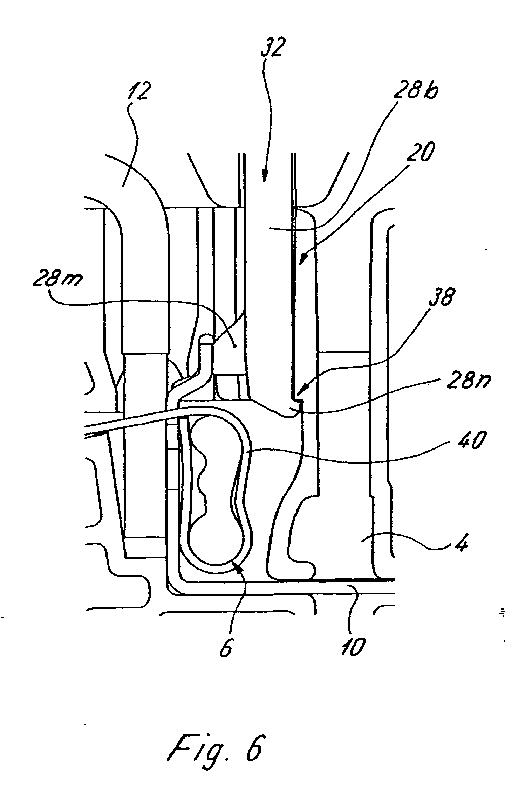

Wie in Fig. 6 genauer zu erkennen, dienen die Halteschenkel 28n, 28o zum Hintergriff eines Gehäusehinterschnittes 38 in der Öffnung 20 des Klemmengehäuses 2. Der Kontaktschenkel 28m kontaktiert dagegen abgewinkelte Enden der Stromschiene 10 im Bereich oberhalb der Federn 40 der Zugfederanschlüsse 6, 8.

Der Sinn dieser Anordnung ist der folgende: Durch die Halteschenkel 28m ist der Teststecker 24 gut gegen ein versehentliches Abziehen senkrecht nach oben gesichert. Durch ein leichtes Verschwenken des Teststeckers 24 lassen sich dagegen die äußeren Kontaktstege 28b,d relativ zum mittleren Kontaktsteg 28c, der sich an der Stromschiene 10 abstützt, verschwenken, so daß die äußeren Halteschenkel 28b, d in Richtung der Kontaktschiene 10 so weit verschwenkt werden, bis es möglich ist, das Teststeckerbein 32 nach oben hin aus der Öffnung 20 der Reihenklemme 2 auszuziehen. Darüber hinaus stellt die Anordnung aber auch sicher, daß das Kontaktbein 32 mit einer vorgegebenen Mindestkontaktkraft gegen das Ende der Stromschiene 10 gepreßt wird.

Die besonders flache Ausbildung der Teststeckergehäuse 26 im Rastermaß (z.B. 3,5mm) ermöglicht im Zusammenspiel mit Rastvorsprüngen 42 am ersten Gehäuseteil 26a und (hier nicht dargestellten) entsprechenden Ausnehmungen in den zweiten Gehäuseteilen 26b zudem in vorteilhafter Weise eine Reihung auch der Teststecker von aneinander gereihten Reihenklemmen 2 und eine Bildung von Teststeckerreihungen vor dem Aufsetzen auf die aneinander gereihten Reihenklemmen.

Neben dem Anschluß 30, der nach Fig. 1 als Zugfederanschluß und nach Fig. 2 als Schraubanschluß ausgebildet ist und der zum Anschließen eines Leiters 47 dient, ist am Teststecker 24 in vorteilhafter Weise ein separater Prüfzugang 48 ausgebildet, welcher es ermöglicht, trotz angeschlossenem Leiter 47 auch direkt über einen Teststecker 50 Prüfabgriffe bzw. Messungen durchzuführen. Der in den Prüfzugang 48 eingesetzte Teststecker 50 und der Zugfederanschluß 30 kontaktieren direkt jeweils eines der zwei sich im wesentlichen entgegengesetzt zur Einsteckrichtung A nach oben erstreckenden Stromschienenstücke 28f,g.

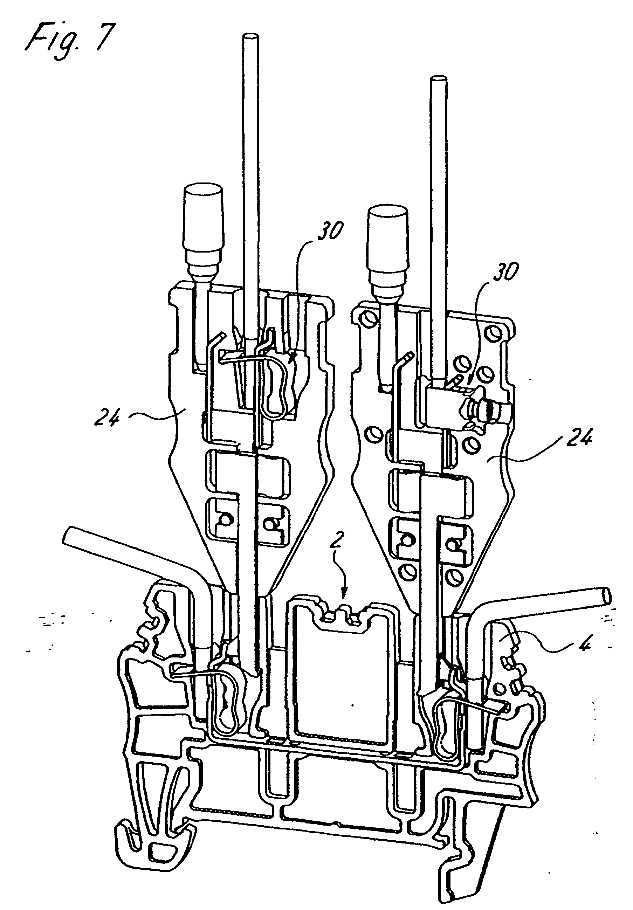

Fig. 7 veranschaulicht noch den Einsatz von zwei Teststeckern 24 zur Prüfung der beiden Anschlüsse 6, 8 des Klemmengehäuses 4. Die beiden Teststecker 24 können aufgrund ihrer kompakten Bauart bequem unabhängig voneinander betätigt werden. Auch die Schwenkbewegung des Teststeckers 24 zum Lösen aus der Reihenklemme 2 ist bei zwei nebeneinander in die Reihenklemme 2 eingesetzten Teststeckern 24 problemlos realisierbar.

### Bezugszeichen

- Durchgangsreihenklemme: 2
- Klemmengehäuse: 4
- Zugfederanschlüsse: 6, 8
- Stromschiene: 10
- Leiter: 12, 14
- Öffnungen: 16, 18
- Öffnungen: 20, 22
- Teststecker: 24
- Vorderteil: 26a
- Rückteil: 26b
- Kunststoffgehäuse: 26
- Kontur: 27
- Teststeckerkontakt: 28
- Steg: 28a
- Kontaktstege: 28b, c, d
- Steg: 28e
- Stromschienenstücke: 28f, g
- Lappen: 28h, i
- Ausnehmungen: 28k,l
- Kontaktschenkel: 28m
- Halteschenkel: 28n, o
- Anschluß: 30
- Teststeckerbein: 32
- Stifte: 34,36
- Aussparung: 37
- Gehäusehinterschnitt: 38
- Federn: 40
- Rastvorsprünge: 42
- Leiter: 47
- Prüfzugang: 48
- Teststecker: 50

## Patentansprüche

1. Teststecker mit Reihenklemmen, insbesondere für Durchgangsreihenklemmen (2) zum Aufrasten auf eine Tragschiene,
a) wobei die Reihenklemmen ein Klemmengehäuse (4), in welchem Leiteranschlüsse (6, 8) angeordnet sind, Öffnungen (16, 18) zum Zuführen der Leiter und weitere Öffnungen (20, 22) aufweisen,
b) und wobei der Teststecker (24) einen Teststeckerkontakt (28) mit einem Kontaktbein (32) zum Einführen in eine der weiteren Öffnungen (20, 22) des Klemmengehäuses (4) und zur Kontaktierung des Leiteranschlusses (6,8) aufweist,
**dadurch gekennzeichnet, daß**
c) das Kontaktbein (32) als mehrlagig gefaltetes Stanz-/Biegeteil ausgelegt ist, welches wenigstens zwei relativ zueinander verschwenkbare, aneinander liegende Kontaktstege (28b,c,d) aufweist, von denen wenigstens einer zur Kontaktierung des Leiteranschlusses (6, 8) und wenigstens ein weiterer zum Verrasten am Klemmengehäuse (4) ausgelegt ist.

2. Teststecker nach Anspruch 1, **dadurch gekennzeichnet, daß** die Leiteranschlüsse als Zugfederanschlüsse (6, 8) ausgebildet sind.

3. Teststecker nach Anspruch 1 oder 2, **gekennzeichnet durch** eine Auslegung im Rastermaß 3,5 mm.

4. Teststecker nach einem der vorstehenden Ansprüche, **gekennzeichnet durch** eine Auslegung des Kontaktbeines (32) zum direkten Eingriff in die als Zugang für einen Schraubendreher dienenden Öffnungen (20, 22) des Klemmengehäuses (4).

5. Teststecker nach einem der vorstehenden Ansprüche, **dadurch gekennzeichnet, daß** der Teststecker (24) ein im wesentlichen aus einem Vorderteil (26a) und einem Rückteil (26b) zusammensetzbares Kunststoffgehäuse (26) aufweist, in dem eine Kontur (27) zum Einlegen der Metallteile des Teststeckers (24) ausgebildet ist.

6. Teststecker nach einem der vorstehenden Ansprüche, **dadurch gekennzeichnet**, der Teststeckerkontakt (28) einen relativ zur Einsteckrichtung (A) in die Reihenklemme (2) senkrecht verlaufenden zentralen Steg (28a) aufweist, an den drei parallel zueinander ausgerichtete Kontaktstege (28b,c,d) und direkt oder über weitere Stege sich im wesentlichen parallel zur Einsteckrichtung (A) erstreckende Stromschienenstücke (28f,g) angeformt sind.

7. Teststecker nach einem der vorstehenden Ansprüche, **dadurch gekennzeichnet**, der Teststeckerkontakt (28) im Bereich des zentralen Steges 28a derart gebogen ist, daß die Kontaktstege (28b,c,d) direkt aneinander liegen und derart das Teststeckerbein (32) ausbilden.

8. Teststecker nach einem der vorstehenden Ansprüche, **dadurch gekennzeichnet, daß** an wenigstens zwei Teststeckerstege jeweils ein senkrecht zur Einsteckrichtung A verlaufender Lappen (28h, 28i) angeformt ist, welche parallel zueinander ausgerichtet sind, vom Teststeckerbein (32) nach außen abstehen und Ausnehmungen (28k, 1) aufweisen, welche an Stiften (34, 36) des Kunststoffgehäuses (26) den Teststeckerkontakt (28) im Kunststoffgehäuse (26) zentrieren.

9. Teststecker nach einem der vorstehenden Ansprüche, **dadurch gekennzeichnet, daß** an einen der Kontaktstege (28c) ein Kontaktschenkel (28m) zum Kontaktieren der Zugfederanschlüsse (6, 8) angeformt ist und daß an die beiden weiteren Kontaktstege (28b, 28d) in der vom Kontaktschenkel (28m) abgewandten Richtung Halteschenkel (28n,o) angeformt sind, welche den Teststecker (24) in der Reihenklemme (2) verrasten.

10. Teststecker nach einem der vorstehenden Ansprüche, **dadurch gekennzeichnet, daß** die Halteschenkel (28n, 280) zum Hintergriff eines Gehäusehinterschnittes (38) in der Öffnung (20) des Klemmengehäuses (2) ausgelegt sind.

11. Teststecker nach einem der vorstehenden Ansprüche, **dadurch gekennzeichnet, daß** der Kontaktschenkel (28n,o) dazu ausgelegt ist, direkt eine Stromschiene (10) oder die Zugfederanschlüsse (6, 8) zu kontaktieren.

12. Teststecker nach einem der vorstehenden Ansprüche, **dadurch gekennzeichnet, daß** die Schraubendreheröffnungen (20, 22) eine im wesentlichen rechteckige Geometrie mit einer einseitigen Aussparung (37) zur Durchführung des Kontaktschenkels (28m) aufweisen.

13. Teststecker nach einem der vorstehenden Ansprüche, **dadurch gekennzeichnet, daß** das Teststeckergehäuse (26) mit Rastvorsprüngen (42) versehen ist, welche im Zusammenspiel mit entsprechenden Ausnehmungen zur Bildung von Teststeckerreihungen vor dem Aufsetzen auf die Reihenklemmen dienen.

14. Teststecker nach einem der vorstehenden Ansprüche, **dadurch gekennzeichnet, daß** der Teststecker einen Leiteranschluß (30) aufweist, der als Zugfeder- oder Schraubanschluß ausgelegt ist.

15. Teststecker nach dem Oberbegriff des Anspruches 1 oder nach einem der vorstehenden Ansprüche, **gekennzeichnet durch** einen Leiteranschluß (30) und einen von diesem getrennt ausgebildeten Prüfzugang (48), vorzugsweise für einen Teststecker.

16. Teststecker nach dem Anspruch 17, **dadurch gekennzeichnet, daß** der Prüfzugang (48) und der Anschluß (30) jeweils direkt die zwei sich im wesentlichen entgegengesetzt zur Einsteckrichtung (A) nach oben erstreckenden Stromschienenstücke (28f,g) des Teststeckerkontaktes (28) kontaktieren.

## Revendications

1. Connecteur de test avec des barrettes à bornes, notamment pour des barrettes à bornes continues (2), destiné à être enclenché sur un profilé support
a) les barrettes à bornes comportant une boîte de bornes (4) dans laquelle sont disposés des raccords pour conducteurs (6, 8), des orifices (16, 18) pour tirer les conducteurs et des orifices supplémentaires (20, 22),
b) et le connecteur de test (24) comportant un contact de connecteur de test (28) avec un bras de contact (32) destiné à être inséré dans l'un des orifices supplémentaires (20, 22) de la boîte de bornes (4) et à contacter le raccord pour conducteur (6, 8),
**caractérisé en ce que**
c) le bras de contact (32) est conçu sous la forme d'une pièce multicouches découpée/cintrée pliée, comportant au moins deux talons de contact adjacents (28b,c,d) pouvant être pivotés l'un vers l'autre, dont au moins l'un est conçu pour contacter le raccord pour conducteur (6, 8), et au moins un autre est conçu pour s'enclencher sur la boîte à bornes (4).

2. Connecteur de test selon la revendication 1, **caractérisé en ce que** les raccords pour conducteur sont conçus sous la forme de raccords à ressort de traction (6, 8).

3. Connecteur de test selon la revendication 1 ou 2, **caractérisé par** une conception dans une dimension modulaire de 3,5 mm.

4. Connecteur de test selon l'une quelconque des revendications précédentes, **caractérisé par** une conception du bras de contact (32) pour un engagement direct dans les orifices (20, 22) de la boîte de bornes (4) faisant office d'accès pour un tournevis.

5. Connecteur de test selon l'une quelconque des revendications précédentes, **caractérisé en ce que** le connecteur de test (24) comporte un boîtier en matière plastique (26) pouvant être assemblé sensiblement à partir d'un élément antérieur (26a) et d'un élément postérieur (26b), dans lequel est conçu un contour (27) pour poser les parties métalliques du connecteur de test (24).

6. Connecteur de test selon l'une quelconque des revendications précédentes, **caractérisé en ce que** le contact du connecteur de tests (28) comporte un talon central (28a) s'étendant sensiblement à la perpendiculaire par rapport au sens insertion (A) dans la barrette à bornes (2) sur laquelle trois talons de contact alignés en parallèle (28b,c,d) et des parties de barres conductrices (28f,g) s'étendant sensiblement à la parallèle du sens d'insertion (A) sont formés directement ou par l'intermédiaire de talons supplémentaires.

7. Connecteur de test selon l'une quelconque des revendications précédentes, **caractérisé en ce que** dans la zone du talon central (28a), le contact de connecteur de test (28) est courbé de façon à ce que les talons de contact (28b,c,d) soient directement adjacents et forment de ce fait le bras du connecteur de test (32).

8. Connecteur de test selon l'une quelconque des revendications précédentes, **caractérisé que** sur au moins deux talons du connecteur de test, est formée respectivement une languette (28h, 28i) s'étendant à la perpendiculaire du sens d'insertion, qui sont alignées en parallèle, dépassent vers l'extérieur à partir du bras du connecteur de test (32) et comportent des évidements (28k,l), qui sur des tiges (34, 36) du boîtier en matière plastique (26) centrent le contact du connecteur de test (28) dans le boîtier en matière plastique (26).

9. Connecteur de test selon l'une quelconque des revendications précédentes, **caractérisé en ce que** sur l'un des talons de contact (28c) est formée une branche de contact (28m) pour contacter les raccords à ressort de traction (6, 8) et **en ce que** des branches de maintien (28n,o) qui enclenchent le connecteur de test (24) dans la barrette à borne (2) sont formées sur les deux talons de contacts supplémentaires (28b, 28d), dans la direction opposée à la branche de contact (28m).

10. Connecteur de test selon l'une quelconque des revendications précédentes, **caractérisé en ce que** les branches de maintien (28n, 28o) sont conçues pour s'accrocher par l'arrière dans une contre-dépouille du boîtier (38), dans l'orifice (20) de la boîte de bornes (2).

11. Connecteur de test selon l'une quelconque des revendications précédentes, **caractérisé en ce que** la branche de contact (28n,o) est conçue pour contacter directement une barre conductrice (10) ou les raccords à ressort de traction (6, 8).

12. Connecteur de test selon l'une quelconque des revendications précédentes, **caractérisé en ce que** les orifices pour tournevis (20, 22) ont une géométrie sensiblement rectangulaire avec une échancrure unilatérale (37) pour le passage de la branche de contact (28m).

13. Connecteur de test selon l'une quelconque des revendications précédentes, **caractérisé en ce que** le boîtier du connecteur de test (26) est muni de saillies d'enclenchement (42), qui en interaction avec des évidements correspondants sont destinées à former des suites de connecteurs de test avant la pose sur les barrettes à bornes.

14. Connecteur de test selon l'une quelconque des revendications précédentes, **caractérisé en ce que** le connecteur de test comporte un raccord pour conducteur (30), qui est conçu sous la forme d'un raccord à ressort de traction ou d'un raccord à visser.

15. Connecteur de test selon le préambule de la revendication 1 ou selon l'une quelconque des revendications précédentes, **caractérisé par** un raccord pour conducteur (30) et par une entrée de test (48) séparée de ce dernier, de préférence pour un connecteur de test.

16. Connecteur de test selon la revendication 17, **caractérisé en ce que** l'entrée de test (48) et le raccord (30) contactent respectivement de façon directe les deux parties de rail conducteur (28f,g) du contact du connecteur de test (28) qui s'étendent vers le haut, sensiblement à l'opposée du sens d'insertion (A).

## Claims

1. Test connector for terminal blocks, in particular through terminal blocks (20) for snapping onto a mounting rail,
a) wherein the terminal blocks comprise a terminal housing (4) wherein conductor connections (6, 8) are located, openings (16, 18) for feeding in the conductors and further openings (20, 22),
b) and wherein the test connector (24) incorporates a test connector contact (28) with a contact leg (32) for introduction into one of the further openings (20, 22) of the terminal housing (4) and for contacting the conductor connection (6, 8),
**characterised in that**
c) the contact leg (32) is designed as a multi-layer folded stamped and bent component with at least two contact lands (28b, c, d) pivotable relative to one another and adjacent to one another, of which at least one is designed for contacting the conductor connection (6, 8) and at least one further is designed for snapping onto the terminal housing (4).

2. Test connector according to claim 1, **characterised in that** the conductor connections are designed as spring connections (6, 8).

3. Test connector according to claim 1 or 2, **characterised by** design in the 3.5 mm reference grid.

4. Test connector according to any of the preceding claims, **characterised in that** the contact leg (32) is designed for direct engagement with the openings (20, 22) of the terminal housing (4) which offer access for a screwdriver.

5. Test connector according to any of the preceding claims, **characterised in that** the test connector has a plastic housing (26) essentially made up of a front part (26a) and a rear part (26b), wherein a contour (27) for the placement of the metal parts of the test connector (24) is formed.

6. Test connector according to any of the preceding claims, **characterised in that** the test connector contact (28) has a central land (28a) extending at right angles to the direction of insertion (A) of the terminal block (2) and featuring three integral contact lands (28b, c, d) extending parallel to one another and, either directly or via further lands, integral bus bar sections (28f, g) extending essentially parallel to the direction of insertion (A).

7. Test connector according to any of the preceding claims, **characterised in that** the test connector contact (28) is bent in the region of the central land (28a), so that the contact lands (28b, c, d) directly adjoin one another, thus forming the test connector leg (32).

8. Test connector according to any of the preceding claims, **characterised in that** at least two test connector lands feature integral tabs (28h, 28i) extending at right angles to the direction of insertion (A), which are oriented parallel to one another, project outwards from the test connector leg (32) and have recesses (28k, 1) to centre the test connector contact (28) within the plastic housing (26) on pins (34, 36) of the plastic housing (26).

9. Test connector according to any of the preceding claims, **characterised in that** one of the contact lands (28c) features an integral contact branch (28m) for contacting the spring connections (6, 8), and **in that** the two further contact lands (28b, 28d) feature retaining legs (28n, o) on the side remote from the contact branch (28m) to lock the test connector (24) in the terminal block (2).

10. Test connector according to any of the preceding claims, **characterised in that** the retaining legs (28n, 28o) are designed for engaging a housing undercut (38) in the opening (20) of the terminal housing (2) from behind.

11. Test connector according to any of the preceding claims, **characterised in that** the contact branch (28n, o) is designed for direct contact with a bus bar (10) or with the spring connections (6, 8).

12. Test connector according to any of the preceding claims, **characterised in that** the screwdriver openings (20, 22) have an essentially rectangular geometry with a one-sided recess (37) for the passage of the contact branch (28m).

13. Test connector according to any of the preceding claims, **characterised in that** the test connector housing (26) is provided with latching projections (42) which, together with matching recesses, are used to form rows of test connectors prior to mounting on the terminal blocks.

14. Test connector according to any of the preceding claims, **characterised in that** the test connector incorporates a conductor connection (30) designed as a spring or screw connection.

15. Test connector according to the preamble of claim 1 or according to any of the preceding claims, **characterised by** a conductor connection (30) and a separate test access (48), preferably for a test connector.

16. Test connector according to claim 17, **characterised in that** the test access (48) and the connection (30) directly contact the two bus bar sections (28f, g) of the test connector contact (28), which extend upwards substantially against the direction of insertion (A).
